# EUROPEAN PATENT APPLICATION

(11) **EP 4 650 495 A1**
(43) Date of publication of application: **19.11.2025**
(21) Application number: 24187710.9
(22) Date of filing: 10.07.2024
(51) Int. Cl.: C30B 23/00, C30B 23/06, C30B 29/36

(54) **MANAGING GROWTH OF SILICON CARBIDE CRYSTALS**

(30) Priority: 13.05.2024 US 202418661875
(71) Applicant: Semiconductor Components Industries, LLC, Scottsdale, AZ 85250 (US)
(72) Inventor: PARTHASARATHY, Santhanaraghavan, Nashua, NH, 03063 (US); DRACHEV, Roman V., Bedford, NH, 03110 (US)
(74) Representative: Manitz Finsterwald Patent- und Rechtsanwaltspartnerschaft mbB

(57) **Abstract**

SiC substrates are in demand for high power applications such as electric vehicles, solar panels, and industrial electronics. A physical vapor transport (PVT) apparatus for growth of silicon carbide (SiC) ingots can be improved by adding moveable heaters. The heaters can be either inductive or resistive. By tightly controlling temperature gradients during the growth phase, and by adding an in-situ anneal following the growth phase, the resulting SiC crystal can be taller, with fewer defects, and can be less likely to crack during subsequent grinding or polishing operations.

## Description

### CROSS-REFERENCE TO RELATED APPLICATION

This patent application claims the benefit of U.S. Patent Application No. 18/661,875, filed on May 13, 2024, and titled "Managing Growth of Silicon Carbide Crystals," which is incorporated by reference herein in its entirety.

### TECHNICAL FIELD

This description relates to a method and apparatus for growing silicon carbide (SiC) crystals for use in the electronics industry. More specifically, this description relates to controlling SiC crystal growth in a physical vapor transport (PVT) furnace.

### BACKGROUND

Silicon carbide can be used as an alternative substrate material to silicon in the fabrication of integrated circuits. Some useful properties of SiC-based microchips, e.g., metal-oxide-semiconductor field effect transistors (SiC MOSFETs) include reduced weight, low power consumption, and the ability to sustain high temperature operation. Whereas silicon devices operate at temperatures up to about 120 degrees C, SiC devices can operate at temperatures as high as 500 degrees C to 800 degrees C, due to the high thermal conductivity of SiC, which is about 3.5 times greater than that of silicon. SiC devices are therefore particularly suited for power applications such as electric vehicles (EVs), hybrid electric vehicles (HEVs), solar panels, and industrial applications. SiC devices have been inserted into EV production in vehicle components such as DC-DC converters and on-board fast battery chargers.

### SUMMARY

In some aspects, the techniques described herein relate to a method of forming silicon carbide (SiC), including: disposing a SiC seed crystal in a seed module in an upper region of a crucible including a SiC precursor; heating the crucible to sublimate the SiC precursor using an inductive heater to heat sides of the crucible and a first moveable heater to heat an end of the crucible; and growing a crystalline SiC ingot by condensing SiC on a bottom surface of the SiC seed crystal.

In some aspects, the techniques described herein relate to a method, wherein heating the crucible to sublimate the SiC precursor includes transforming the SiC precursor from a powder to a gas.

In some aspects, the techniques described herein relate to a method, wherein heating the crucible using the inductive heater includes energizing a radio frequency (RF) coil that wraps around the sides of the crucible.

In some aspects, the techniques described herein relate to a method, wherein heating the crucible using the first moveable heater includes energizing one or more moveable inductive coils disposed in a plane parallel to the end of the crucible.

In some aspects, the techniques described herein relate to a method, wherein heating the crucible using the first moveable heater includes energizing one or more moveable resistive elements disposed in a plane parallel to the end of the crucible.

In some aspects, the techniques described herein relate to a method, wherein heating the crucible raises a temperature of the crucible to within a range of about 1800 C to about 2500C.

In some aspects, the techniques described herein relate to a method, wherein heating the crucible uses a second moveable heater to heat another end of the crucible.

In some aspects, the techniques described herein relate to a method, wherein altering a position of the first moveable heater and the second moveable heater adjusts a growth rate of the crystalline SiC ingot.

In some aspects, the techniques described herein relate to an apparatus, including: a crucible having an upper region and a lower region; a silicon carbide (SiC) precursor disposed in the lower region of the crucible; a SiC seed disposed in the upper region of the crucible; an inductive heater surrounding sidewalls of the crucible; a first moveable heater disposed at an upper end of the crucible; and a second moveable heater disposed at a lower end of the crucible.

In some aspects, the techniques described herein relate to an apparatus, wherein the first moveable heater and the second moveable heater are moveable along a vertical axis of the crucible.

In some aspects, the techniques described herein relate to an apparatus, wherein the first moveable heater and the second moveable heater include inductive heating elements.

In some aspects, the techniques described herein relate to an apparatus, wherein the first moveable heater and the second moveable heater include resistive heating elements.

In some aspects, the techniques described herein relate to an apparatus, wherein the resistive heating elements include at least one of tungsten, molybdenum, or graphite.

In some aspects, the techniques described herein relate to an apparatus, wherein the first moveable heater and the second moveable heater can be positioned independently at different distances from the upper end and the lower end of the crucible.

In some aspects, the techniques described herein relate to an apparatus, wherein a pressure inside the crucible is maintained between about 0.1 Torr and about 50 Torr.

In some aspects, the techniques described herein relate to an apparatus, wherein the crucible further includes an outer shell, and the first moveable heater and the second moveable heater are disposed inside the outer shell.

In some aspects, the techniques described herein relate to an apparatus, wherein the crucible further includes an outer shell, and the inductive heater is disposed outside the outer shell.

In some aspects, the techniques described herein relate to a system, including: a process chamber for growing a SiC crystalline ingot; a fixed heater disposed around sides of the process chamber; a first moveable heater disposed at a first end of the process chamber; a second moveable heater disposed at a second end of the process chamber; and a processor programmed to control a first temperature of the first moveable heater and a second temperature of the second moveable heater, according to a target schedule.

In some aspects, the techniques described herein relate to a system, wherein the processor is programmed to energize the fixed heater, the first moveable heater, and the second moveable heater while growing the SiC crystalline ingot.

In some aspects, the techniques described herein relate to a system, wherein the processor is programmed to energize the first moveable heater and the second moveable heater to perform an annealing process after growing the SiC crystalline ingot.

### BRIEF DESCRIPTION OF THE DRAWINGS

FIGs. 1-3 are cross-sectional views of a physical vapor transport (PVT) apparatus, according to implementations of the present disclosure.
FIG. 4A is a top plan view of an induction heater, according to implementations of the present disclosure.
FIGs. 4B and 4C are simulated temperature maps of the heater shown in FIG. 4A and a nearby susceptor, according to implementations of the present disclosure.
FIG. 5 is a cross-sectional view showing temperature gradients during a crystal growth process, according to implementations of the present disclosure.
FIG. 6A is a simulated contour plot of temperature across a SiC boule, according to implementations of the present disclosure.
FIGs. 6B and 6C are simulated contour plots of stress in a SiC boule according to implementations of the present disclosure.
FIG. 7 is a flow diagram illustrating a method of forming a SiC boule, according to an implementation of the present disclosure.
FIG. 8 is a system block diagram of a computer system that can provide feedback control for the process shown in FIG. 7, according to a possible implementation of the present disclosure.

Aspects of the present disclosure are best understood from the following detailed description when read with the accompanying figures. It is noted that, in accordance with common practice in the industry, various features are not necessarily drawn to scale. Dimensions of the various features may be arbitrarily increased or reduced for clarity of discussion. In the drawings, like reference symbols may indicate like and/or similar components (elements, structures, etc.) in different views. The drawings illustrate generally, by way of example, but not by way of limitation, various implementations discussed in the present disclosure.

Reference symbols shown in one drawing may not be repeated for the same, and/or similar elements in related views. Reference symbols that are repeated in multiple drawings may not be specifically discussed with respect to each of those drawings but are provided for context between related views. Also, not all like elements in the drawings are specifically referenced with a reference symbol when multiple instances of an element are illustrated.

### DETAILED DESCRIPTION

Silicon carbide ingots for use in the fabrication of integrated circuits can be formed (e.g., grown) in a physical vapor transport (PVT) furnace. A PVT furnace can have the form of a vertical cylindrical chamber, or crucible, that has a seed crystal at one end. The crucible can receive source materials of silicon and carbon, which are heated until they vaporize. The resulting silicon and carbon gases rise within the chamber, and when the gas encounters the seed crystal, the gas crystallizes around the seed crystal, causing crystal growth radially outward as well as axially outward in a downward direction. Such crystal growth forms a cylindrical boule that can later be sliced into SiC wafers for use as substrates in a semiconductor fabrication process.

Process control during SiC crystal growth is challenging. At least one problem that occurs during the process of crystal growth is that temperature gradients or fluctuations can disrupt crystallization, resulting in irregularities or defects, e.g., dislocations, in the crystalline structure of the boule. To decrease (e.g., minimize) the dislocation density within the boule, it is desirable to tightly control the growth process to maintain a constant growth rate and to limit both axial and radial temperature gradients. Another way to reduce crystal defects in the boule is to control the crystal-gas interface so as to maintain a convex shape throughout the growth process. The rate at which the source material is depleted can also affect the geometry of the crystal growth.

To control temperature gradients, heaters can be disposed at both ends of the chamber, and along the chamber walls. The heaters can be induction heaters, e.g., radio frequency (RF) type induction heaters, or resistive heating elements. Temperature control can be adjusted by altering the number of heaters, the types of heaters, their locations and spacing, and by modulating the power applied to the heaters. In addition, some heaters can be fixed while others are moveable.

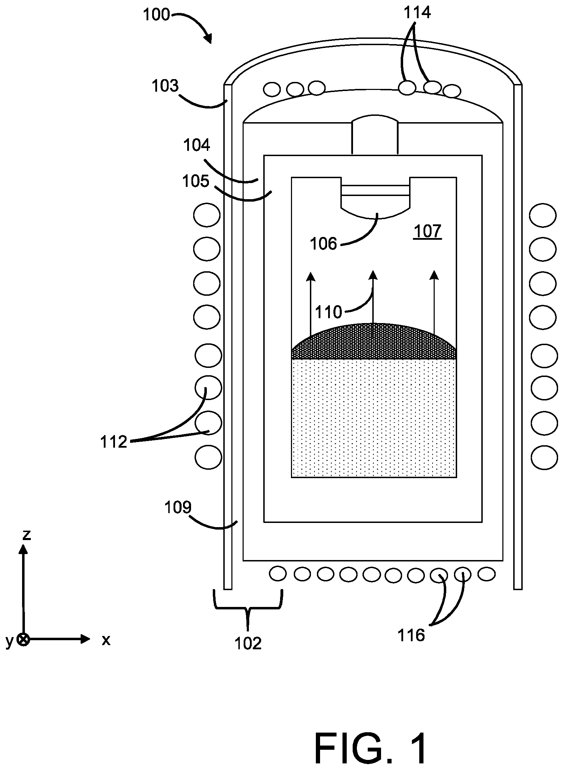

FIGs. 1-3 show cross-sectional views of a PVT furnace 100, in accordance with some implementations of the present disclosure. In some implementations, the PVT furnace 100, e.g., a sublimation furnace, can include an outer shell 102, a seed crystal 106, a crucible 105, side heaters 112, a top heater 114, and a bottom heater 116. In some implementations, the outer shell 102 can be a multi-layer cylindrical structure that includes an outer chamber wall 103 and a thermal insulation sleeve 104 outside the crucible 105. In some implementations, the crucible 105 can be a closed container that defines a growth cell 107. The growth cell 107 may be evacuated so that the SiC crystalline boule is grown in a high purity, low pressure environment. In some implementations, the outer chamber wall 103 can be made of quartz, the thermal insulation sleeve 104 can be made of low density graphite, and the crucible 105 can be made of high density graphite. Because graphite is highly conductive of both heat and electricity, the graphite material supports inductive heating of the crucible 105, surrounding the growth cell 107. In some implementations, an air gap 109 can separate the outer chamber wall 103 from the thermal insulation sleeve 104. In some implementations, a thickness of the air gap 109 can range between, for example, about 3 mm and about 7 mm. In some implementations, another inert gas, e.g., nitrogen gas (N₂), can be substituted for air in the air gap 109. In some implementations, the SiC seed crystal 106 can have a dimension in the growth direction of about 1 mm. In some implementations, the SiC seed crystal 106 can be disposed within a seed module.

In some implementations, the side heaters 112 can be disposed outside the outer shell 102, while the top heater 114 and the bottom heater 116 can be disposed inside the outer shell 102, e.g., inside the "hot zone." In some implementations, the top heater 114 mainly controls the temperature of the seed crystal 106 and the bottom heater 116 mainly controls the temperature of the source material. The top heater 114 and the bottom heater 116 can be considered as vertical heating elements because they influence temperature gradients in the +/- z direction. In some implementations, the side heaters 112 can be considered as horizontal heating elements because they influence temperature gradients in the x-y, or radial, planes along the z-axis. In some implementations, the side heaters 112 take the form of fixed RF induction coils that wrap around the outer shell 102, to surround sidewalls of the crucible 105, where turns of the coil(s) are represented in FIGs. 1-3 by circles. The induction coils of the side heaters 112 induce electric currents to flow within the crucible 105.

In the PVT furnace 100, source material is disposed in a lower region of the crucible 105 and the seed crystal 106 is disposed in an upper region of the crucible 105. The SiC source materials, e.g., a SiC precursor, may be in the form of a powder having a 1:1 ratio of silicon to carbon. The crucible 105 can be heated by the bottom heater 116 to a temperature in a range of, for example, about 1800 degrees C to about 2500 degrees C, until the solid SiC source materials sublimate to form a gas 110. The gas 110 rises within the growth cell 107 toward the seed crystal 106, which is maintained at a lower temperature than the gas 110. When the gas 110 encounters the seed crystal 106, the gas 110 condenses onto the seed crystal 106, causing crystal growth to progress radially outward from the seed crystal 106 and axially downward in the - z direction.

FIGs. 1-3 show three different configurations for the top heater 114 and the bottom heater 116 in the PVT furnace 100, in accordance with some implementations of the present disclosure. FIG. 1 illustrates the use of one or more static, e.g., fixed, RF induction coils e.g., "pancake heaters" for the top heater 114 and the bottom heater 116, which are represented by ovals. The pancake heaters are individual, localized heating elements that can operate in similar fashion as induction burners used in a kitchen cooktop. The lateral (x-y) distance (e.g., spacing) between the pancake heaters can be designed to control the number of heating elements that are directly underneath the crucible 105 and directly above the seed crystal 106. Power applied to the RF coil(s) can also be modulated to control the rate of heating the crucible 105. One advantage of induction heaters is that the heater can remain cooler than the target. In some implementations, the RF coils can reach a temperature of about 90 degrees C, while the temperature of the crucible 105 is about 2000 degrees C.

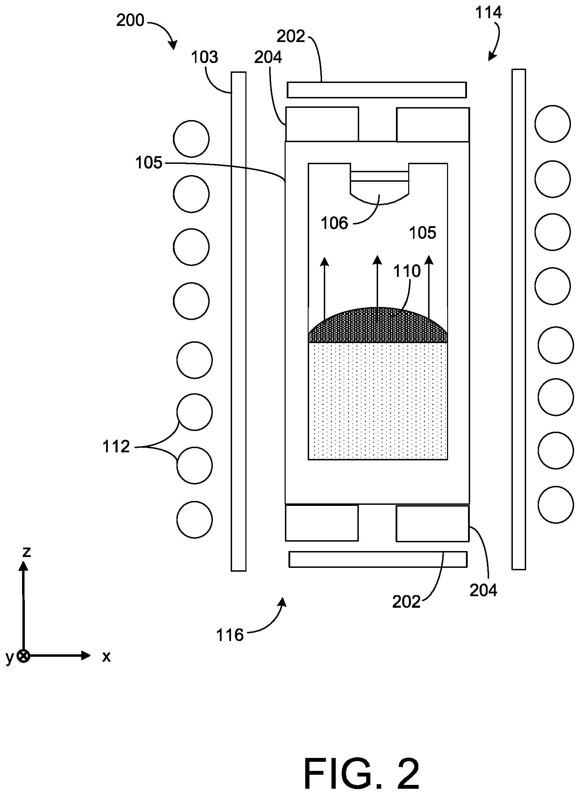

FIG. 2 illustrates a PVT furnace 200 that includes a moveable induction heater 202 for the top heater 114 and the bottom heater 116, in accordance with some implementations of the present disclosure. Each moveable induction heater 202 spans the width of the crucible 105. In some implementations of the bottom heater 116, a moveable induction heater 202 can be mounted to, e.g., attached to, a moveable platform 204 configured to alter the z-distance between the moveable induction heater 202 and a lower end of the crucible 105. In some implementations of the top heater 114, a moveable induction heater 202 can be mounted to, e.g., attached to, a moveable platform 204 configured to alter the z-distance between the moveable induction heater 202 and an upper end of the crucible 105 that houses the seed crystal 106. The moveable induction heaters 202 used as the top heater 114 and the bottom heater 116 can be positioned independently at different distances from respective upper and lower ends of the crucible 105. In some implementations, multiple bottom heaters 116 can be moveable RF coil heaters that permit altering the vertical (z-direction) distance between the bottom heaters 116 and the crucible 105.

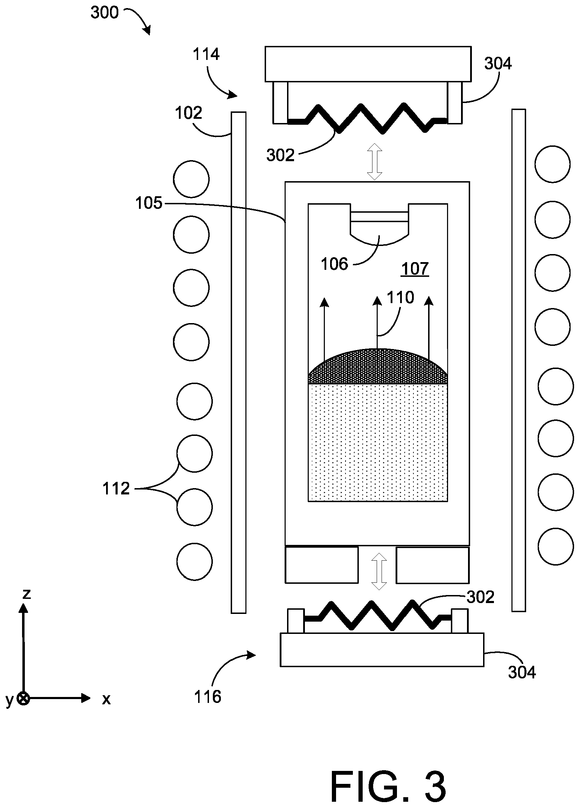

FIG. 3 illustrates a PVT furnace 300 that includes a moveable resistive heater 302 for the top heater 114 and the bottom heater 116, in accordance with some implementations of the present disclosure. Each moveable resistive heater 302 spans the width of the crucible 105. In some implementations, the moveable resistive heater 302 can include, as materials, one or more of tungsten, molybdenum, and graphite. In some implementations of the bottom heater 116, a moveable resistive heater 302 can be mounted to, e.g., attached to, a moveable platform 304 configured to alter the z-distance between the moveable resistive heater 302 and the crucible 105. In some implementations of the top heater 114, a moveable resistive heater 302 can be mounted to, e.g., attached to, a moveable platform 304 configured to alter the z-distance between the moveable resistive heater 302 and the seed crystal 106.

In some implementations, the moveable induction heater 202 or the moveable resistive heater 302 can be positioned prior to beginning a process of crystal growth. In some implementations, the moveable induction heater 202 or the moveable resistive heater 302 can be re-positioned at various times during the process of crystal growth. In some implementations, the growth process for a full SiC ingot can occur over a time interval of about 10 days to about three weeks, in contrast to silicon ingots that can be fully formed in about 1-2 days. In some implementations, the SiC boule can withstand about +/- 1 degree of temperature variation during the crystal growth process.

Use of a moveable top heater 114 can improve control of radial temperature gradients to maintain a stable radial growth rate of the crystal and can limit radial variation of the electrical resistivity of the boule to produce SiC wafers with excellent center-to-edge uniformity. The radial crystal growth rate depends on temperature, radial temperature gradient, and pressure inside the growth cell 107. In some implementations, the chamber pressure inside the growth cell 107 can be in a range of about 0.1 Torr to about 50 Torr. A moveable top heater 114 can be used to dynamically balance the radial temperature gradients. Use of a moveable top heater 114 can also help to prevent seed burnout. Seed burnout can occur if the seed crystal 106 is consumed by the gas 110 instead of the gas 110 condensing onto the seed crystal 106 and continuing the crystallization process.

Use of a moveable bottom heater 116 provides control of source depletion, and maintains a target carbon to silicon ratio in the source material and in the boule.

A combination of the moveable top heater 114 and the moveable bottom heater 116 can provide control of axial temperature gradients along the z-axis, between the source material and the seed crystal. Control of axial temperature gradients can help maintain a stable axial growth rate of the crystal, resulting in a taller ingot. Control of axial temperature gradients can also limit axial variation of the electrical resistivity of the boule to produce SiC wafers with a low wafer-to-wafer variation. Control of axial temperature gradients can also help maintain a convex crystal-gas interface shape to reduce defects, e.g., dislocations, within in the boule to ensure growth of a high quality boule. Growth at the surface of the seed crystal 106 proceeds in a radial direction from the center at the z-axis to the edge of the boule as long as the boule has a convex shape.

In some implementations, the top heater 114 and the bottom heater 116 can also provide in-situ crystal annealing to reduce thermal stress within the boule following the crystal growth process. In some implementations, the annealing step can occur after the crystal growth is complete. Reducing the thermal stress within the boule can prevent cracking during subsequent surface grinding, slicing, and polishing processes of the boule or of SiC wafers cut from the boule. Reducing thermal stress can also improve epitaxial growth at the surface of the SiC wafers.

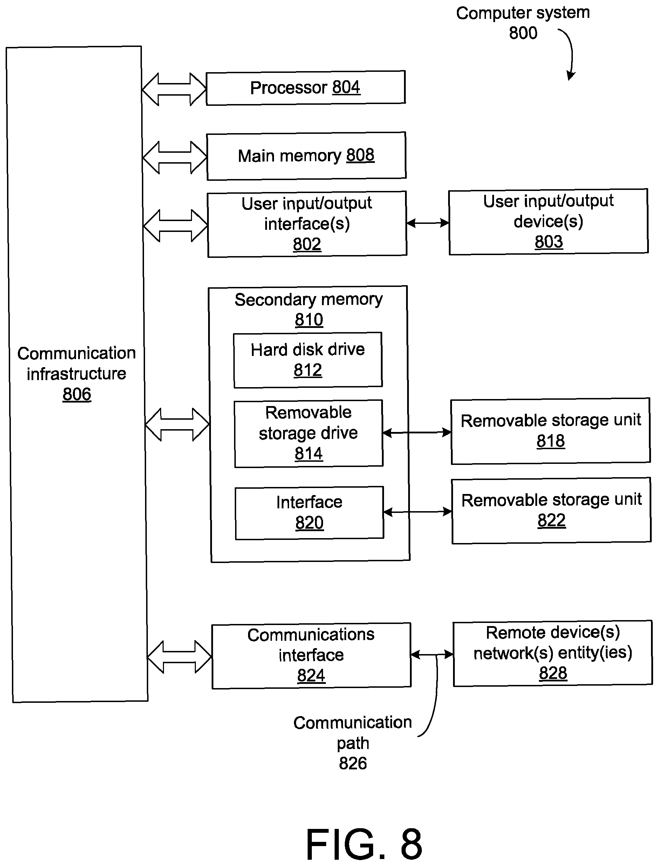

In some implementations, movement of the moveable induction heater 202 or the moveable resistive heater 302 can be dynamically coordinated using an automatic feedback control system, as described in further detail below with reference to FIG. 8. The feedback control system can sense temperatures at different z-coordinates during the crystal growth process and move the heaters accordingly, to achieve a set of target temperatures.

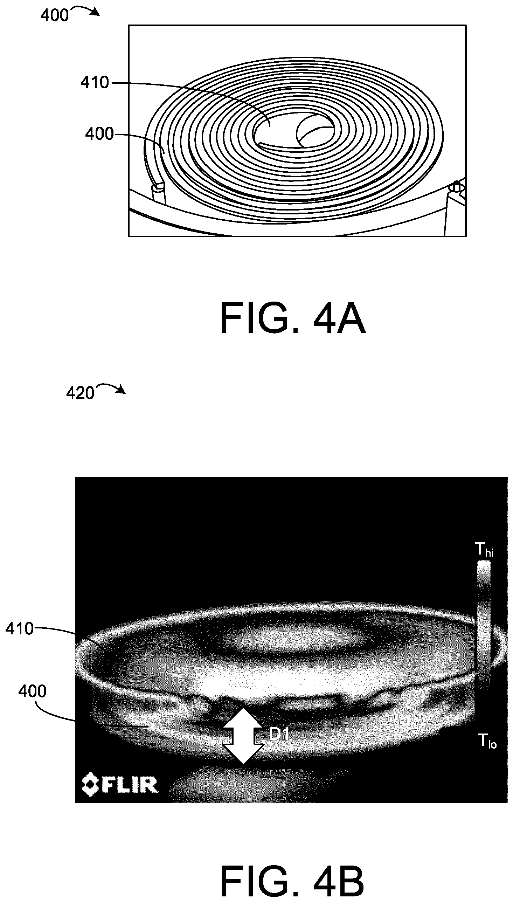

FIGs. 4A-4C illustrate the effect of a moveable inductive coil on a nearby target, in accordance with some implementations of the present disclosure. FIG. 4A is photograph showing a perspective view 420 of an example of the moveable induction heater 202 e.g., an induction coil pancake heater 400, disposed near a target, e.g., near a graphite susceptor 410. The graphite susceptor 410 can represent, for example, either a graphite seed module in which the seed crystal 106 is mounted, or the bottom end of the graphite crucible 105 containing the source material.

FIG. 4B shows a simulated temperature map illustrating the effect on temperature gradients of placing of the induction coil pancake heater 400 at a distance D1 away from the susceptor 410. In some implementations, the distance D1 can be in a range of about 0.9 inch to about 1.1 inch, e.g., within the hot zone of the PVT furnace 100. Simulation inputs further include an applied power of 6.5 kW. The temperature gradient shown in FIG. 4B ranges from a minimum temperature Tₗₒ between about 75 degrees C and 85 degrees C to a maximum temperature Tₕᵢ between about 680 degrees C and about 690 degrees C. Although the induction coil pancake heater 400 remains at a low temperature near the bottom of the temperature range, e.g., near Tₗₒ, the susceptor 410 can be heated, through induction, to a much higher temperature near the top of the temperature range e.g., near Tₕᵢ within a time interval of about 110 seconds to about 130 seconds.

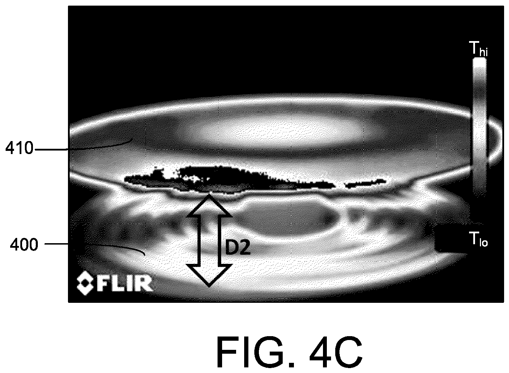

FIG. 4C shows a simulated temperature map illustrating the effect on temperature gradients of placing of the induction coil pancake heater 400 at a distance D2 away from the susceptor 410. In some implementations, the distance D2 can be in a range of about 1.8 inches to about 2.2 inches, e.g., within the hot zone of the PVT furnace 100. Simulation inputs further include an applied power of 8.5 kW. The temperature gradient shown in FIG. 4C ranges from a minimum temperature Tₗₒ between about 75 degrees C and 85 degrees C to a maximum temperature Tₕᵢ between about 700 degrees C and about 800 degrees C. Although the induction coil pancake heater 400 remains at a low temperature near the bottom of the temperature range, e.g., near Tₗₒ, the graphite susceptor 410 can be heated, through induction, to a much higher temperature near the top of the temperature range e.g., near Tₕᵢ within a time interval of about 135 seconds to about 165 seconds.

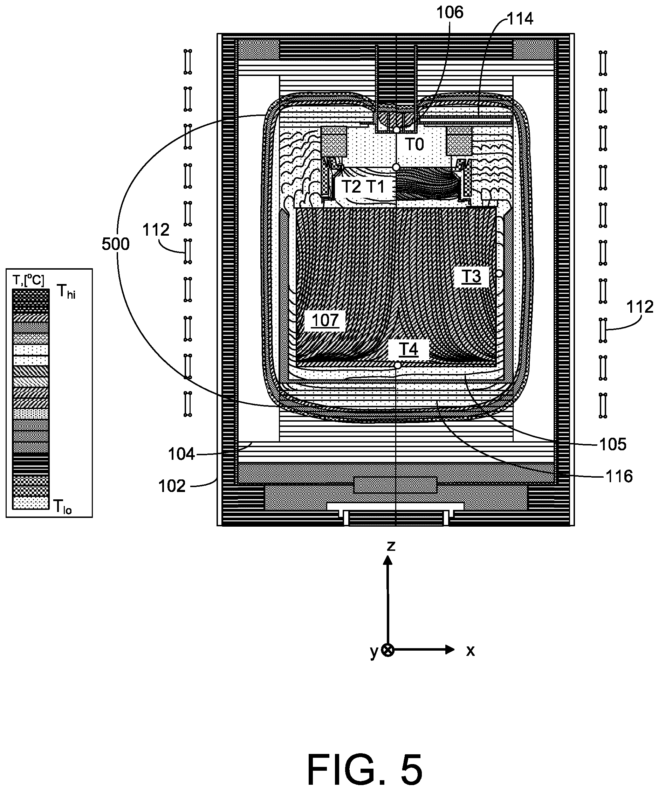

FIG. 5 is a cross-sectional view of a simulation region 500 within the PVT furnace 100, in accordance with some implementations of the present disclosure. As shown in FIG. 5, the PVT furnace 100 is equipped with RF coil induction side heaters 112, a top heater 114, and a bottom heater 116. The top heater 114 and the bottom heater 116 are each in the form of a moveable resistance heater 302. In some implementations, the moveable resistive heaters 302 can be resistive pancake heaters. The simulation region 500 illustrates temperature gradients inside the growth cell 107. In particular, five locations are identified at which corresponding temperatures T0, T1, T2, T3, and T4 are monitored during a simulation of SiC growth. T0 monitors the temperature of the crucible 105. T1 monitors the temperature of the seed crystal 106; T1 monitors the temperature of the center of the boule at a point along the z-axis; T2 monitors the edge of the SiC seed; T3 monitors the maximum temperature of the crucible; and T4 monitors the temperature at the center of the bottom of the crucible 105.

Temperatures of the bottom heater 116 can range between a minimum, Tₗₒ between about 25 degrees C to about 35 degrees C and a maximum temperature Tₕᵢ between about 2000 degrees C to about 2200 degrees C. Temperatures of the top heater 114 can be between a minimum, Tₗₒ in a range of about 1740 degrees C to about 1770 degrees C and a maximum temperature Tₕᵢ in a range of about 2000 degrees C to about 2200 degrees C.

Inputs to the simulation include the chamber pressure 0.5 Torr, a power level of 1.5 kW applied to energize the top heater 114, a power level of 1.5 kW applied to energize the bottom heater 116, the temperature of the crucible (T0) is set to 1920 degrees C, the SiC seed thickness of 1.0 mm, the SiC seed outer diameter (OD) of 150 mm, the SiC boule thickness of 39.0 mm, and the SiC boule outer diameter (OD) of 154 mm.

The simulation models the temperature response to the use of various combinations of heaters. According to the simulation results, the monitored temperatures T1, T2, and T3 are all within about 20% of 2100 degrees C. However, examination of the differential temperatures, e.g., temperature gradients T2-T1 and T3-T1, reveals that the smallest temperature gradient occurs when both the top heater 114 and the bottom heater 116 are in use, and the largest temperature gradient occurs when the top heater 114 is not in use. Thus, the benefits of the top heater 114 and the bottom heater 116 are demonstrated. Conversely, the largest temperature gradients occur when power applied to energize the side heater 112 is highest, and the lowest temperature gradients occur when power applied to energize the side heater 112 is lowest. These results suggest that temperature variation degrades with use of the side heater 112.

The simulation also models an anneal step during the cool-down stage following growth of the boule, The purpose of the anneal is to relax stress within the crystal structure to reduce defects and prevent cracking. When a maximum power level of about 9 kW is applied to energize the side heaters 112, while the top heater 114 and the bottom heater 116 are powered off (0 kW), both the shear stress and the Mises stress are shown to remain at their maximum values. This result demonstrates the futility of attempting to anneal the boule using only fixed induction side heaters 112. When the top heater 114 and the bottom heater 116 are each powered on at 1.5 kW, while the side heaters 112 are at their minimum power of about 4.7 kW, both the shear stress and the Mises stress are minimized This result shows the advantage of using the top heater 114 and the bottom heater to anneal the crystalline boule.

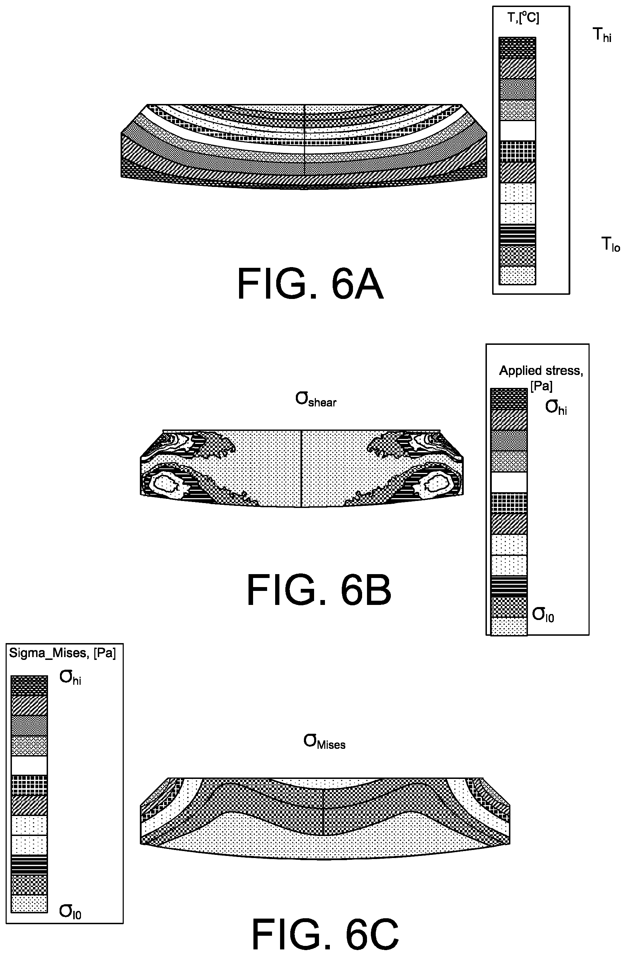

FIGs. 6A-6C illustrate simulation results characterizing the SiC boule, in accordance with some implementations of the present disclosure. The simulation results shown in FIGs. 6A-6C correspond to the PVT furnace 100 configured as shown in FIG. 5. FIG. 6A is a 2D contour plot illustrating temperature variation ΔT across the SiC boule; FIG. 6B is a 2D contour plot illustrating applied shear stress in the SiC boule that can generate defects such as basal plane dislocations (BPD); FIG. 6C is a 2D contour plot illustrating Von Mises stress in the SiC boule that can lead to cracking in subsequent process operations.

As shown in FIG. 6A the temperature of the SiC boule ranges between about 1950 degrees C and about 2250 degrees C; as shown in FIG, 6B, simulated values of shear stress range from a minimum σₗₒ of about 0.45 mega-Pascals (MPa) to a maximum σₕᵢ of about 0.86 MPa. As shown in FIG, 6C, simulated values of Mises stress range from a minimum σₗₒ of about 14 MPa to a maximum σₕᵢ of about 24 MPa.

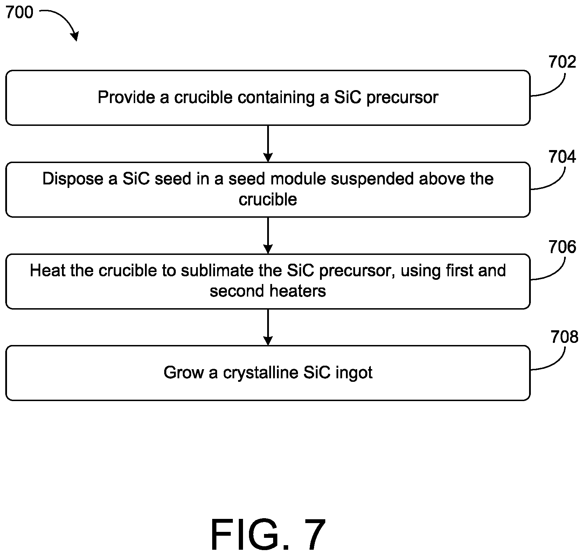

FIG. 7 is a flow chart illustrating a method 700 of forming a SiC boule in accordance with some implementations of the present disclosure. Operations 702-708 of the method 700 can be carried out to form the SiC boule, according to some implementations as described above with reference to FIGs. 1-3, 4A, 4B, 4C, 5, 6A, 6B, and 6C. Operations of the method 700 can be performed in a different order, or not performed, depending on specific applications. It is noted that the method 700 may not completely form a SiC boule. Accordingly, it is understood that additional processes can be provided before, during, or after method 700, and that some of these additional processes may be briefly described herein.

At 702, the method 700 includes providing a crucible containing a SiC precursor e.g., the crucible 105 of a sublimation furnace, e.g., the PVT furnace 100. In some implementations, the crucible 105 can have an upper region and a lower region, wherein the SiC precursor is provided in the lower region.

At 704, the method 700 includes disposing a SiC seed crystal, e.g., the seed crystal 106, in a seed module suspended in the upper region of the crucible 105.

At 706, the method 700 includes heating the crucible 105 to sublimate the SiC precursor, using a first heater and a second heater, e.g., the bottom heater 116 and the top heater 114. Alternatively, the first heater can be the side heater 112 and the second heater can be the bottom heater 116; or the first heater can be the side heater 112 and the second heater can be the top heater 114. In some implementations, at least one of the first heater and the second heater is disposed inside an outer shell of the PVT furnace 100. In some implementations, at least one of the first heater and the second heater is moveable.

At 708, the method 700 includes growing a crystalline SiC ingot, using the first and second heaters to control temperature gradients during the growth process. Use of the first and second heaters during and/or after the growth process can result in a longer ingot with a lower defect density and less stress than can be obtained using only one heater, or only fixed heaters.

FIG. 8 illustrates an example computing system 800 that can provide feedback control for implementations of the present disclosure. The computing system 800 can be any well-known computing system capable of performing the functions and operations described herein. For example, and without limitation, the computing system 800 can provide a hardware platform for implementing the process control scheme(s) described above. The computing system 800 can be used, for example, to execute one or more operations in the method 700, which describes an example method for forming a SiC boule. In some implementations, the computing system 800 can serve as a feedback control system for the PVT furnace 100. For example, the computing system 800 can be implemented as a controller coupled to the PVT furnace 100. The controller can be configured to monitor one or more temperatures associated with the PVT furnace 100 and, in response, to adjust operation of the heaters, in particular, of the moveable heaters described above, to provide enhanced process control during a crystal growth process and/or a post-anneal process.

The computing system 800 includes one or more processors (also called central processing units, or CPUs), such as a processor 804. The processor 804 is connected to a communication infrastructure or bus 806. The computing system 800 also includes input/output device(s) 803, such as monitors, keyboards, pointing devices, etc., that communicate with a communication infrastructure or bus 806 through input/output interface(s) 802. The processor 804 can receive instructions to implement functions and operations described herein-e.g., method 700 of FIG. 7-via input/output device(s) 803. For example, the processor 804 can be programmed to energize one or more of the side heater 112, the top heater 114, or the bottom heater 116, while growing the SiC crystalline ingot, or while performing an annealing process after growing the SiC crystalline ingot. The computing system 800 also includes a primary or main memory 808, such as random access memory (RAM). The main memory 808 can include one or more levels of cache. The main memory 808 has stored therein control logic (e.g., computer software) and/or data. In some implementations, the control logic (e.g., computer software) and/or data can include one or more of the operations described above with respect to the method 700 of FIG. 7.

The computing system 800 can also include one or more secondary storage devices or secondary memory 810. The secondary memory 810 can include, for example, a hard disk drive 812 and/or a removable storage device or drive 814. The removable storage drive 814 can be a floppy disk drive, a magnetic tape drive, a compact disk drive, an optical storage device, tape backup device, and/or any other storage device/drive.

The removable storage drive 814 can interact with a removable storage unit 818. The removable storage unit 818 includes a computer usable or readable storage device having stored thereon computer software (control logic) and/or data. The removable storage unit 818 can be a floppy disk, magnetic tape, compact disk, DVD, optical storage disk, thumb drive, and/or any other computer data storage device. The removable storage drive 814 reads from and/or writes to removable storage unit 818 in a well-known manner.

In some implementations, the secondary memory 810 can include other means, instrumentalities or other approaches for allowing computer programs and/or other instructions and/or data to be accessed by the computing system 800. Such means, instrumentalities or other approaches can include, for example, a removable storage unit 822 and an interface 820. Examples of the removable storage unit 822 and the interface 820 can include a program cartridge and cartridge interface (such as that found in video game devices), a removable memory chip (such as an EPROM or PROM) and associated socket, a memory stick and USB port, a memory card and associated memory card slot, and/or any other removable storage unit and associated interface. In some implementations, the secondary memory 810, the removable storage unit 818, and/or the removable storage unit 822 can include one or more of the operations described above with respect to the method 700 of FIG. 7.

In some implementations, the computing system 800 can further include a communication or network interface 824. The communications interface 824 enables the computing system 800 to communicate and interact with any combination of remote devices, remote networks, remote entities, etc. (individually and collectively referenced by remote devices 828). For example, the communication interface 824 can allow the computing system 800 to communicate with the remote devices 828 over a communications path 826, which can be wired and/or wireless, and which can include any combination of LANs, WANs, the Internet, etc. Control logic and/or data can be transmitted to and from the computing system 800 via the communications path 826.

The operations in the preceding implementations can be implemented in a wide variety of configurations and architectures. Therefore, some or all of the operations in the preceding implementations-e.g., the method 700 of FIG. 7-can be performed in hardware, in software or both. In some implementations, a tangible apparatus or article of manufacture comprising a tangible computer useable or readable medium having control logic (software) stored thereon is also referred to herein as a computer program product or program storage device. This includes, but is not limited to, the computing system 800, the main memory 808, the secondary memory 810 and the removable storage units 818 and 822, as well as tangible articles of manufacture embodying any combination of the foregoing. Such control logic, when executed by one or more data processing devices (such as the computing system 800), causes such data processing devices to operate as described herein.

As described above, the addition of top and bottom heaters to a PVT system, e.g., the PVT system 100, can assist in controlling SiC crystal formation, especially when the top and bottom heaters are moveable. The benefits of tighter process control can be obtained primarily by reducing axial and radial temperature variation, e.g., temperature gradients across the boule. A post-growth annealing operation is shown to reduce both shear stress and Van Mises stress in the boule, which can reduce defects and prevent failures at subsequent processing steps.

It will be understood that, in the foregoing description, when an element, such as a layer, a region, or a substrate, is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, top, bottom, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Some implementations may be implemented using various semiconductor processing and/or packaging techniques. Some implementations may be implemented using various types of semiconductor device processing techniques associated with semiconductor substrates including, but not limited to, for example, silicon (Si), silicon carbide (SiC), gallium arsenide (GaAs), gallium nitride (GaN), and/or so forth.

While certain features of the described implementations have been illustrated as described herein, many modifications, substitutions, changes, and equivalents will now occur to those skilled in the art. For instance, features illustrated with respect to one implementation can, where appropriate, also be included in other implementations. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or sub-combinations of the functions, components and/or features of the different implementations described.

## Claims

1. A method of forming silicon carbide (SiC), comprising:
disposing a SiC seed crystal in a seed module in an upper region of a crucible including a SiC precursor;
heating the crucible to sublimate the SiC precursor using an inductive heater to heat sides of the crucible and a first moveable heater to heat an end of the crucible; and
growing a crystalline SiC ingot by condensing SiC on a bottom surface of the SiC seed crystal.

2. The method of claim 1, wherein
heating the crucible to sublimate the SiC precursor comprises transforming the SiC precursor from a powder to a gas, or
heating the crucible using the inductive heater includes energizing a radio frequency (RF) coil that wraps around the sides of the crucible, or
heating the crucible using the first moveable heater includes energizing one or more moveable inductive coils disposed in a plane parallel to the end of the crucible, or
heating the crucible using the first moveable heater includes energizing one or more moveable resistive elements disposed in a plane parallel to the end of the crucible, or
heating the crucible raises a temperature of the crucible to within a range of about 1800 C to about 2500C, or
heating the crucible uses a second moveable heater to heat another end of the crucible.

3. The method of claim 2, further comprising altering a position of the first moveable heater and the second moveable heater to adjust a growth rate of the crystalline SiC ingot.

4. An apparatus, comprising:
a crucible having an upper region and a lower region;
a silicon carbide (SiC) precursor disposed in the lower region of the crucible;
a SiC seed disposed in the upper region of the crucible;
an inductive heater surrounding sidewalls of the crucible;
a first moveable heater disposed at an upper end of the crucible; and
a second moveable heater disposed at a lower end of the crucible.

5. The apparatus of claim 4, wherein the first moveable heater and the second moveable heater are moveable along a vertical axis of the crucible.

6. The apparatus of claim 4, wherein the first moveable heater and the second moveable heater include inductive heating elements.

7. The apparatus of claim 4, wherein the first moveable heater and the second moveable heater include resistive heating elements.

8. The apparatus of claim 7, wherein the resistive heating elements include at least one of tungsten, molybdenum, or graphite.

9. The apparatus of claim 4, wherein the first moveable heater and the second moveable heater can be positioned independently at different distances from the upper end and the lower end of the crucible.

10. The apparatus of claim 4, wherein a pressure inside the crucible is maintained between about 0.1 Torr and about 50 Torr.

11. The apparatus of claim 4, wherein the crucible further includes an outer shell, and the first moveable heater and the second moveable heater are disposed inside the outer shell.

12. The apparatus of claim 4, wherein the crucible further includes an outer shell, and the inductive heater is disposed outside the outer shell.

13. A system, comprising:
a process chamber for growing a SiC crystalline ingot;
a fixed heater disposed around sides of the process chamber;
a first moveable heater disposed at a first end of the process chamber;
a second moveable heater disposed at a second end of the process chamber; and
a processor programmed to control a first temperature of the first moveable heater and a second temperature of the second moveable heater, according to a target schedule.

14. The system of claim 13, wherein the processor is programmed to energize the fixed heater, the first moveable heater, and the second moveable heater while growing the SiC crystalline ingot.

15. The system of claim 13, wherein the processor is programmed to energize the first moveable heater and the second moveable heater to perform an annealing process after growing the SiC crystalline ingot.
